(19) Europäisches Patentamt
European Patent Office
Office européen des brevets

(11) **EP 0 810 728 B1**

(12) **FASCICULE DE BREVET EUROPEEN**

(45) Date de publication et mention de la délivrance du brevet:
**31.10.2001 Bulletin 2001/44**

(51) Int Cl.7: **H03H 11/12**

(21) Numéro de dépôt: **97410056.2**

(22) Date de dépôt: **28.05.1997**

(54) **Filtre audio analogique pour fréquences aigues**

Analoger Tonfilter für hohe Frequenzen

Analog audio filter for high frequencies

(84) Etats contractants désignés:
**DE FR GB IT**

(30) Priorité: **31.05.1996 FR 9606947**

(43) Date de publication de la demande:
**03.12.1997 Bulletin 1997/49**

(73) Titulaire: **STMicroelectronics S.A.**
**94250 Gentilly (FR)**

(72) Inventeur: **Federspiel, Lionel**
**38000 Grenoble (FR)**

(74) Mandataire: **de Beaumont, Michel**
**1, rue Champollion**
**38000 Grenoble (FR)**

(56) Documents cités:
**EP-A- 0 511 536**          **US-A- 3 769 606**

- **PROCEEDINGS OF THE CUSTOM INTEGRATED CIRCUITS CONFERENCE, SAN DIEGO, 15 - 18 MAY, 1989, no. CONF. 11, 15 Mai 1989, INSTITUTE OF ELECTRICAL AND ELECTRONICS ENGINEERS, pages 1611-1615, XP000075655 ROESGEN J P ET AL: "AN ANALOG FRONT END CHIP FOR V.32 MODEMS"**

**Description**

La présente invention concerne un filtre audio analogique de correction des fréquences aiguës. L'invention s'applique plus particulièrement à la réalisation d'un filtre actif destiné à être intégré dans un mélangeur analogique, par exemple, d'une carte-son pour micro-ordinateur.

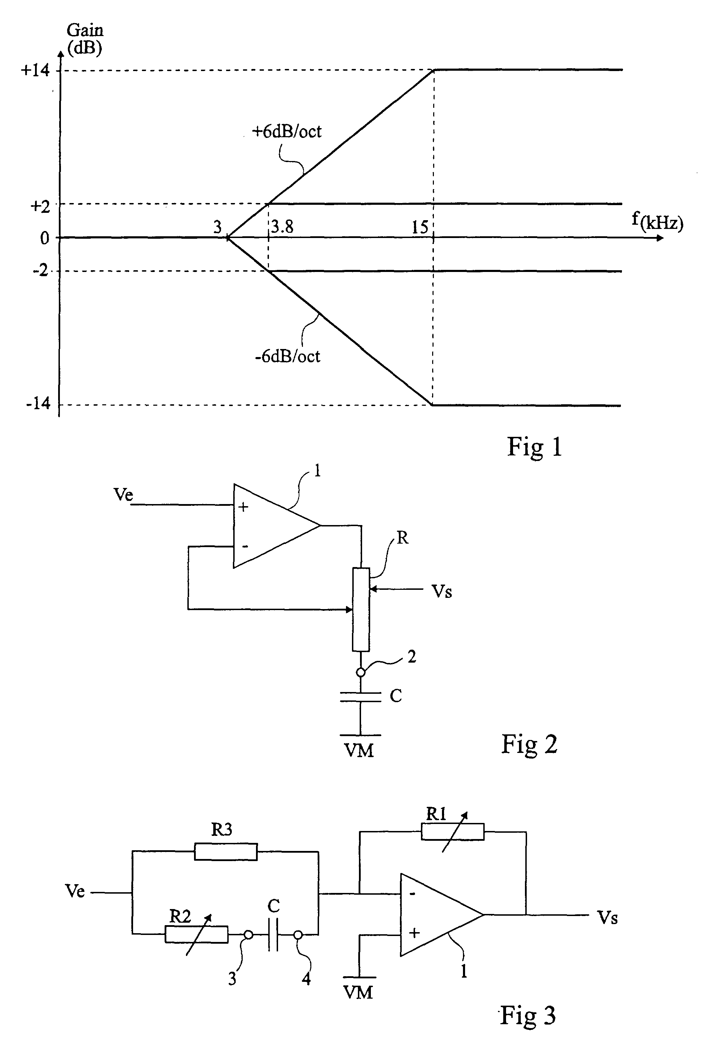

Un tel filtre actif de correction des fréquences aiguës doit respecter un gabarit donné. La figure 1 représente, sous forme de caractéristique gain-fréquence, le gabarit d'un filtre audio de correction des fréquences aiguës auquel s'applique la présente invention.

La fonction de transfert du filtre doit posséder un pôle fixe, généralement à 3 kHz et O dB, et un pôle fonction du gain de l'amplificateur. La variation en fréquences du pôle variable suit une pente de $\pm 6$ dB par octave à partir du pôle fixe. Dans l'exemple représenté à la figure 1, le gain linéaire est unitaire (0 dB) pour les fréquences inférieures à 3 kHz. Pour un gain de $\pm 2$ dB, la fréquence de coupure est de 3,8 kHz. Pour un gain de $\pm 14$ dB, cette fréquence de coupure devient de 15 kHz.

Dans des applications aux cartes-son pour micro-ordinateurs, le gabarit du filtre est généralement symétrique par rapport à 0 dB. Pour réaliser un tel filtre actif, amplificateur ou atténuateur, on a généralement recours à un filtre programmable.

La figure 2 représente un premier exemple de montage classique pour réaliser un filtre actif respectant un gabarit tel qu'illustré en figure 1.

Ce montage utilise un amplificateur différentiel 1 monté en suiveur. Un signal analogique d'entrée Ve est envoyé sur une entrée non-inverseuse de l'amplificateur 1. Une sortie de l'amplificateur 1 est reliée, par l'intermédiaire d'une résistance R en série avec un condensateur de filtrage C, à une borne d'alimentation correspondant au potentiel médian Vm, par exemple la masse, entre des potentiels d'alimentation de l'amplificateur 1. La résistance R possède deux bornes intermédiaires pour définir deux résistances variables de réglage, respectivement, de la fréquence de coupure et du gain du filtre. Une première borne intermédiaire est reliée à une entrée inverseuse de l'amplificateur 1 et la valeur de la résistance, entre la sortie de l'amplificateur 1 et son entrée inverseuse, fixe la fréquence de coupure du filtre. Une deuxième borne intermédiaire de la résistance R sert à prélever un signal de sortie Vs, la valeur de la résistance entre la borne de sortie de l'amplificateur 1 et cette deuxième borne intermédiaire fixant le gain du filtre.

Hormis le condensateur C dont la valeur (de l'ordre de plusieurs dizaines de nanofarads) est trop importante pour en permettre l'intégration, tous les composants du filtre sont généralement intégrés au sein d'un même circuit, par exemple un mélangeur analogique. Ainsi, le fonctionnement d'un filtre tel que représenté à la figure 1 nécessite que le circuit auquel il est intégré possède une borne 2 de raccordement du condensateur C.

Un inconvénient d'un montage suiveur tel que représenté à la figure 2 est qu'il présente une impédance de sortie élevée, la tension de sortie Vs étant prélevée par l'intermédiaire d'un élément résistif. Cela nécessite d'associer le montage représenté à la figure 2 à un étage suiveur d'adaptation d'impédance.

Dans un montage suiveur tel que représenté à la figure 2, le réglage de la valeur de la résistance R entre la borne de sortie de l'amplificateur 1 et la deuxième borne intermédiaire de la résistance R permet de faire fonctionner le montage, soit en amplificateur, soit en atténuateur.

La figure 3 représente un deuxième exemple de montage classique de filtre audio analogique. On utilise ici un amplificateur différentiel 1 monté en inverseur. Une entrée non-inverseuse de l'amplificateur 1 est reliée à un potentiel Vm correspondant généralement au potentiel médian d'une tension d'alimentation (non représentée) de l'amplificateur 1. Une sortie de l'amplificateur 1 délivre le signal filtré Vs et est reliée, par l'intermédiaire d'une première résistance variable R1, à une entrée inverseuse de l'amplificateur 1. Le signal à filtrer Ve est envoyé, par l'intermédiaire d'une deuxième résistance variable R2 en série avec un condensateur C, à l'entrée inverseuse de l'amplificateur 1, une résistance fixe R3 étant montée en parallèle sur l'association série de la résistance R2 et du condensateur C.

En basses fréquences, c'est-à-dire pour des fréquences inférieures à 3 kHz selon le gabarit de la figure 1, le gain de l'amplificateur est fixé par le quotient de la résistance R1 sur la résistance R3. La résistance R1 est donc ajustée pour correspondre à la valeur de la résistance R3 afin que le montage ait un gain unitaire. Le gain en hautes fréquences du montage inverseur représenté à la figure 3 correspond au quotient de la résistance R1 sur l'association en parallèle des résistances R2 et R3. La résistance R2 sert à régler la fréquence de coupure du filtre.

Si un montage inverseur tel que représenté à la figure 3 pallie aux inconvénients d'un montage suiveur tel que représenté en figure 2, il présente l'inconvénient de nécessiter, pour son intégration, deux bornes, respectivement 3 et 4, de raccordement du condensateur C.

Le montage représenté à la figure 3 correspond à un montage amplificateur. Pour réaliser un montage atténuateur, l'association en série de la résistance R2 et du condensateur C est placée en parallèle sur la résistance R1. Lors de l'intégration du montage, on utilise généralement des commutateurs pour obtenir un filtre amplificateur ou un filtre atténuateur à partir d'un même amplificateur 1.

La présente invention vise à pallier les inconvénients des montages connus, en proposant un filtre audio analogique de correction des fréquences aiguës qui puisse être intégré en ne nécessitant qu'une seule borne de raccordement d'un condensateur de filtrage, tout en évitant le recours à un amplificateur suiveur supplémentaire pour adapter l'impédance de sortie.

La présente invention vise également à proposer un filtre actif analogique à commande numérique.

Pour atteindre ces objets, la présente invention prévoit un filtre actif analogique comportant :

un amplificateur différentiel dont une sortie délivre un signal filtré et dont une entrée non-inverseuse est reliée à un potentiel médian entre des potentiels d'alimentation de l'amplificateur ;
une première association série d'une première résistance fixe et d'une première résistance variable entre une borne d'entrée d'un signal à filtrer et une borne d'entrée inverseuse de l'amplificateur ;
une deuxième association série d'une deuxième résistance fixe et d'une deuxième résistance variable entre la sortie de l'amplificateur et son entrée inverseuse ; et
une troisième résistance variable en série avec un condensateur de filtrage, entre un point-milieu d'une desdites associations série et ledit potentiel médian.

Selon un mode de réalisation de la présente invention, les résistances et l'amplificateur sont réalisés sous forme de circuit intégré, une première borne de la troisième résistance variable étant reliée à une borne de raccordement du condensateur externe au circuit intégré, et une deuxième borne de la troisième résistance variable étant reliée au point-milieu d'une desdites associations série.

Selon un mode de réalisation de la présente invention, la troisième résistance variable est reliée au point-milieu de la première association série, ledit filtre constituant un amplificateur.

Selon un mode de réalisation de la présente invention, la troisième résistance variable est reliée au point-milieu de la deuxième association série, ledit filtre constituant un atténuateur.

Selon un mode de réalisation de la présente invention, le filtre comporte des moyens de commutation propres à sélectionner le point-milieu auquel est connectée la troisième résistance variable.

Selon un mode de réalisation de la présente invention, lesdits moyens de commutation sont constitués de deux commutateurs CMOS.

Selon un mode de réalisation de la présente invention, chacune des résistances variables est constituée de résistances fixes montées en série et associées à des commutateurs.

Selon un mode de réalisation de la présente invention, les commutateurs constitutifs des résistances variables sont des transistors MOS à canal N.

Selon un mode de réalisation de la présente invention, les commutateurs constitutifs des résistances variables sont commandés par des signaux numériques, chaque résistance variable comportant un même nombre de commutateurs et chaque signal numérique commandant simultanément un commutateur de chaque résistance variable.

Selon un mode de réalisation de la présente invention, le filtre est appliqué à la correction de fréquences aiguës d'un signal audio analogique.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 3 qui ont été décrites précédemment sont destinées à exposer l'état de la technique et le problème posé ;
la figure 4 représente un mode de réalisation d'un filtre selon l'invention en montage amplificateur ;
la figure 5 représente la caractéristique gain-pulsation d'un filtre tel que représenté à la figure 4 ;
la figure 6 représente un mode de réalisation d'un filtre selon l'invention en montage atténuateur ; et
la figure 7 représente un mode de réalisation d'un filtre analogique programmable selon la présente invention.

Pour des raisons de clarté, les mêmes éléments ont été désignés par les mêmes références aux différentes figures.

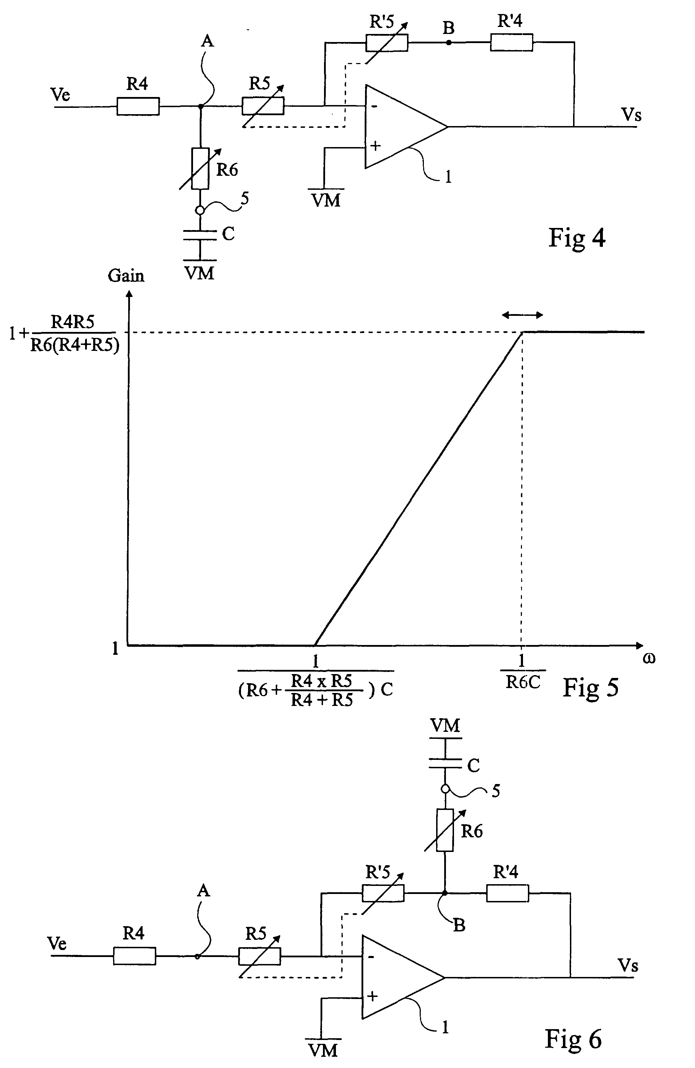

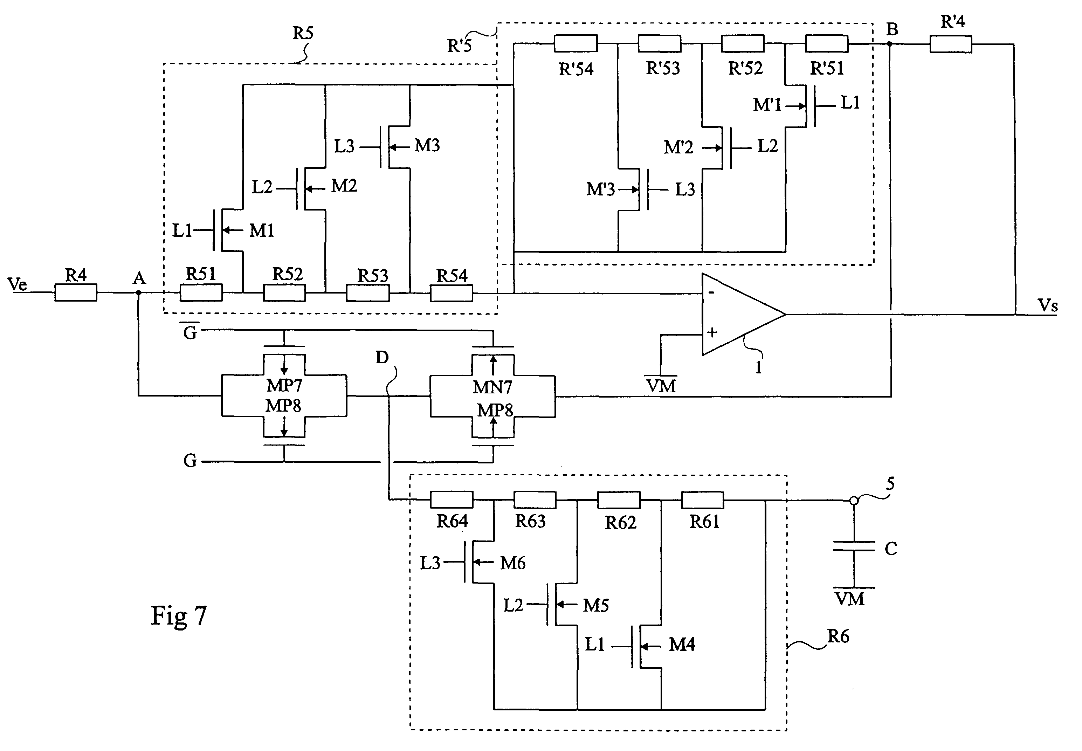

On décrira tout d'abord, en relation avec les figures 4 à 6, des montages de base de la présente invention pour la réalisation de filtres amplificateur et atténuateur. Puis, on indiquera, en relation avec la figure 7, un mode de réalisation d'un filtre analogique programmable pouvant fonctionner à la fois en amplificateur et en atténuateur.

La figure 4 représente schématiquement un mode de réalisation d'un filtre audio analogique monté en amplificateur selon la présente invention.

Le montage de base d'un filtre selon la présente invention comporte un amplificateur différentiel 1 dont une entrée non-inverseuse est portée à un potentiel Vm correspondant au potentiel médian d'une tension d'alimentation (non représentée) de l'amplificateur 1. Une entrée inverseuse de l'amplificateur 1 reçoit, par l'intermédiaire d'une première résistance fixe R4, montée en série avec une première résistance variable R5, un signal analogique Ve à filtrer. La boucle de réaction de l'amplificateur 1 comporte une deuxième résistance variable R'5 montée en série avec une deuxième résistance fixe R'4 entre la borne inverseuse et une borne de sortie de l'amplificateur 1 délivrant un signal Vs filtré.

Un condensateur de filtrage C est relié entre le potentiel Vm et, par l'intermédiaire d'une troisième résistance variable R6, le point-milieu A de l'association série des résistances R4 et R5.

Les résistances R4 et R'4 possèdent la même valeur et les résistances R5 et R'5 sont ajustées à une même valeur. Ainsi, le gain linéaire du montage en basse fréquence est unitaire.

La figure 5 représente la caractéristique gain-pulsation d'un montage tel que représenté à la figure 4.

Par souci de clarté, on utilisera par la suite les notations R4 et R5 pour désigner les valeurs prises, respectivement, par les résistances R4 et R'4 et par les résistances R5 et R'5.

Une première pulsation de coupure (correspondant au pôle fixe de la figure 1) est donnée par la relation :

$$1/[(R6 + R4.R5/(R4 + R5)).C].$$

Une deuxième pulsation de coupure du filtre selon l'invention est donnée par la relation 1/(R6.C). Cette deuxième pulsation de coupure correspond au pôle variable du gabarit de la figure 1.

Le gain linéaire du filtre est unitaire pour les pulsations inférieures à la première pulsation de coupure. Le gain du filtre est égal à 1 + R4.R5/[R6.(R4 + R5)] pour les fréquences égales ou supérieures à la deuxième pulsation de coupure.

Comme les valeurs de la résistance R6 et du condensateur C interviennent dans les deux pôles du filtre, on utilise le fait que les résistances R5 et R'5 sont variables pour compenser les variations de la résistance R6 afin de maintenir un pôle fixe dans la fonction de transfert du filtre.

Comme il ressort de la figure 4, une seule borne 5 est désormais suffisante pour raccorder le condensateur C à un circuit intégré contenant à la fois l'amplificateur 1 et les différentes résistances. De plus, l'impédance de sortie du montage est faible dans la mesure où le signal filtré est directement prélevé sur la sortie de l'amplificateur différentiel 1.

La figure 6 représente schématiquement un filtre, selon la présente invention, monté en atténuateur.

Selon l'invention, la seule distinction entre le montage amplificateur et le montage atténuateur est que l'association série de la résistance R6 et du condensateur C est reliée, non plus au point A, mais au point-milieu B de l'association série des résistances R'5 et R'4 dans la boucle de réaction de l'amplificateur 1.

La caractéristique gain-pulsation d'un tel filtre est similaire à celle représentée à la figure 5 en étant inversée par rapport à l'axe des pulsations.

Un avantage de la présente invention est que, pour transformer un montage amplificateur en un montage atténuateur, ou inversement, il suffit de déplacer une borne de la résistance R6 du point A au point B, ou inversement.

Cet avantage ressortira mieux de la description suivante faite en relation avec la figure 7 qui illustre un mode de réalisation d'un filtre analogique programmable selon la présente invention.

Selon l'invention, on utilise deux commutateurs CMOS pour connecter la résistance R6 soit au point A, soit au point B. Un premier commutateur est constitué de deux transistors MOS en série, respectivement MP7 à canal P et MN7 à canal N, connectés entre les points A et B. Un deuxième commutateur est constitué de deux transistors MOS en série, respectivement MN8 à canal N, et MP8 à canal P, connectés entre les points A et B. Une première borne de la résistance R6 est reliée à la borne externe 5 de raccordement du condensateur C. Une deuxième borne de la résistance R6 est reliée au point-milieu D des deux commutateurs CMOS montés en parallèle, défini par les drains communs des transistors MP7, MN7, MN8 et MP8.

La commutation de la connexion de la résistance R6 s'effectue, par exemple, au moyen de signaux numériques G et $\overline{G}$ envoyés sur les grilles respectives des transistors des commutateurs CMOS.

Les transistors MN8 et MP8 reçoivent un signal G. Les transistors MP7 et MN7 reçoivent un signal $\overline{G}$ inverse du signal G. Quand le signal G est à l'état haut (le signal $\overline{G}$ étant à l'état bas), les transistors MP7 et MN8 conduisent et les transistors MN7 et MP8 sont bloqués. La résistance R6 est connectée au point A et le montage fonctionne en amplificateur. Quand le signal G est à l'état bas (le signal $\overline{G}$ étant à l'état haut) les transistors MN7 et MP8 conduisent, les transistors MP7 et MN8 étant bloqués. La résistance R6 est alors connectée au point B et le montage fonctionne en atténuateur.

Un avantage de la présente invention est qu'en ayant recours à des commutateurs CMOS pour la connexion de la résistance R6, on minimise les distorsions harmoniques générées par les résistances des transistors MOS à l'état passant. En effet, les résistances drain-source des transistors constitutifs des commutateurs se retrouvent en série avec la résistance R6. En ayant recours à des commutateurs CMOS, on minimise l'influence des résistances série des transistors dans la mesure où deux de ces résistances série sont toujours en parallèle dans l'association avec la résistance R6.

Les résistances variables R5, R'5 et R6 sont chacune réalisées au moyen d'un réseau de résistances fixes associées à des commutateurs, de préférence, des transistors MOS à canal N.

Ainsi, dans l'exemple représenté à la figure 7, la résistance R5 est constituée d'une association série de quatre résistances fixes R51, R52, R53 et R54, les résistances R52 à R54 étant propres à être court-circuitées au moyen de transistors MOS à canal N M1, M2 et M3. Une première borne de la résistance variable R5 est constituée par une première borne de la résistance R51 et une deuxième borne de la résistance variable R5 est constituée par une deuxième borne de la résistance R54. Une deuxième borne de la résistance R51 est reliée à une première borne de la résistance R52 et, par l'intermédiaire d'un transistor M1, à la deuxième borne de la résistance R54. Une deuxième borne de la résistance R52 est reliée à une première borne de la résistance R53 et, par l'intermédiaire d'un transistor M2, à la deuxième borne de la résistance R54. Une deuxième borne de la résistance R53 est reliée à une première borne de la résistance R54 et, par l'intermédiaire d'un transistor M3, à la deuxième borne de la résistance R54.

Les résistances R'5 et R6 sont constituées par des montages similaires. La résistance variable R'5 est constituée d'une association série de résistances fixes R'51, R'52, R'53 et R'54, et de trois transistors MOS à canal N, respectivement M'1, M'2 et M'3. La résistance variable R6 est constituée d'une association série de résistances fixes R61, R62, R63 et R64, et de trois transistors MOS à canal N, respectivement M4, M5 et M6.

Pour réaliser les commutateurs des résistances variables R5, R'5 et R6, on utilise de préférence des transistors MOS à canal N dans la mesure où ils ne voient qu'une faible variation de tension à leurs bornes et ne génèrent donc que peu de distorsions harmoniques. En effet, selon l'invention, les résistances R4 et R'4 sont nettement supérieures aux résistances R5, R'5 et R6. Par exemple, les résistances R4 et R'4 sont de l'ordre d'une centaine de kΩ et les résistances R5, R'5 et R6 sont de l'ordre d'une dizaine de kΩ. Ainsi, la chute de tension dans ces résistances variables représente de l'ordre de 10% de la chute de tension dans les résistances R4 et R'4.

La commande des transistors MOS constitutifs des résistances variables R5, R'5 et R6 est également effectuée au moyen de signaux numériques.

Selon l'invention, et pour permettre la compensation des variations dans la valeur de la résistance R6 par des variations dans les valeurs respectives des résistances R5 et R'5 afin de maintenir le pôle fixe du gabarit de la figure 1, chaque résistance R5, R'5 et R6 reçoit les mêmes signaux de commande.

Les transistors M1, M'1 et M4 sont commandés par un premier signal L1. Les transistors M2, M'2 et M5 sont commandés par un deuxième signal L2. Les transistors M3, M'3 et M6 sont commandés par un troisième signal L3.

A titre d'exemple particulier et en supposant que les résistances sont convenablement dimensionnées, lorsque les trois signaux L1, L2 et L3 sont simultanément dans un état bas, tous les transistors NMOS constitutifs des résistances variables R5, R'5 et R6 sont bloqués et l'amplification ou l'atténuation réalisée par le montage est maximale. Lorsque le signal L1 est dans un état haut, les signaux L2 et L3 étant dans un état bas, la résistance R6 correspond à la somme des résistances R62, R63 et R64 tandis que les résistances R5 et R'5 correspondent, respectivement, aux résistances R51 et R'51. Le gain du montage est alors, par exemple, de +2 dB selon l'état du signal G. Lorsque le signal L2 est dans un état haut, les signaux L1 et L3 étant dans un état bas, la résistance R6 correspond à la somme des résistances R63 et R64, les résistances R5 et R'5 correspondant, respectivement, aux sommes des résistances R51, R52 et R'51, R'52. Le gain du montage est, par exemple, de ±4 dB en fonction de l'état du signal G.

Lorsque le signal L3 est dans un état haut, les signaux L1 et L2 étant dans un état bas, la résistance R6 correspond à la résistance R64, les résistances R5 et R'5 correspondant aux sommes respectives des résistances R51 à R53 et R'51 à R'53. Le gain du montage est, par exemple, de ±6 dB en fonction de l'état du signal G.

Le pas de réglage des résistances R5, R'5 et R6 dépend du nombre de commutateurs et de résistances fixes utilisés pour leur réalisation. On notera que, selon l'invention, les résistances R5, R'5 et R6 comportent cependant toutes le même nombre de résistances fixes et de commutateurs.

Bien entendu, la présente invention est susceptible de diverses variantes et modifications qui apparaîtront à l'homme de l'art. En particulier, le dimensionnement des différents composants constitutifs du filtre selon l'invention est à la portée de l'homme de l'art en fonction des indications fonctionnelles données ci-dessus.

De plus, bien que l'on ait fait référence dans la description qui précède à un filtre dont le gabarit est symétrique par rapport à 0 dB, on notera que le filtre peut posséder un gabarit dissymétrique. Pour ce faire, il suffit de modifier la génération des signaux de commande L1, L2 et L3 selon que le filtre doit fonctionner en amplificateur ou en atténuateur.

En outre, bien que l'on ait fait référence dans la description qui précède à un filtre analogique audio, l'invention s'applique plus généralement à tout type de filtre analogique programmable dont le gabarit présente un pôle fixe de gain unitaire et un pôle variable se déplaçant sur une pente de gain linéaire et déterminée.

**Revendications**

**1.** Filtre actif analogique comportant un amplificateur différentiel (1) dont une sortie délivre un signal filtré (Vs) et dont une entrée non-inverseuse est reliée à un potentiel médian (Vm) entre des potentiels d'alimentation de l'amplificateur (1), **caractérisé en ce qu'**il comporte :

une première association série d'une première résistance fixe (R4) et d'une première résistance variable (R5) entre une borne d'entrée d'un signal à filtrer (Ve) et une borne d'entrée inverseuse de l'amplificateur (1) ;

une deuxième association série d'une deuxième résistance fixe (R'4) et d'une deuxième résistance variable (R'5) entre la sortie de l'amplificateur (1) et son entrée inverseuse ; et

une troisième résistance variable (R6) en série avec un condensateur de filtrage (C), entre un point-milieu (A, B) d'une desdites associations série (R4, R5 ; R'4, R'5) et ledit potentiel médian (Vm).

**2.** Filtre selon la revendication 1, **caractérisé en ce que** les résistances (R4, R5, R'4, R'5, R6) et l'amplificateur (1) sont réalisés sous forme de circuit intégré, une première borne de la troisième résistance variable (R6) étant reliée à une borne (5) de raccordement du condensateur (C) externe au circuit intégré, et une deuxième borne de la troisième résistance variable (R6) étant reliée audit point-milieu (A, B) d'une desdites associations série.

**3.** Filtre selon la revendication 1 ou 2, **caractérisé en ce que** la troisième résistance variable (R6) est reliée au point-milieu (A) de la première association série (R4, R5), le filtre constituant un amplificateur.

**4.** Filtre selon la revendication 1 ou 2, **caractérisé en ce que** la troisième résistance variable (R6) est reliée au point-milieu (B) de la deuxième association série (R'4, R'5), le filtre constituant un atténuateur.

**5.** Filtre selon l'une quelconque des revendications 1 à 4, **caractérisé en ce qu'**il comporte des moyens de commutation (MP7, MN7, MN8, MP8) propres à sélectionner le point-milieu (A, B) auquel est connectée la troisième résistance variable (R6).

**6.** Filtre selon la revendication 5, **caractérisé en ce que** lesdits moyens de commutation sont constitués de deux commutateurs CMOS (MP7, MN7 ; MN8, MP8).

**7.** Filtre selon l'une quelconque des revendications 1 à 6, **caractérisé en ce que** chacune des résistances variables (R5 ; ; R'5 ; R6) est constituée de résistances fixes (R51, R52, R53, R54 ; R'51, R'52, R'53, R'54 ; R61, R62, R63, R64) montées en série et associées à des commutateurs (M1, M2, M3 ; M'1, M'2, M'3 ; M4, M5, M6).

**8.** Filtre selon la revendication 7, **caractérisé en ce que** les commutateurs (M1, M2, M3 ; M'1, M'2, M'3 ; M4, M5, M6) constitutifs des résistances variables (R5 ; R'5 ; R6) sont des transistors MOS à canal M.

**9.** Filtre selon la revendication 7 ou 8, **caractérisé en ce que** les commutateurs (M1, M2, M3 ; M'1, M'2, M'3 ; M4, M5, M6) constitutifs des résistances variables (R5 ; R'5 ; R6) sont commandés par des signaux numériques (L1, L2, L3), chaque résistance variable (R5, R'5, R6) comportant un même nombre de commutateurs et chaque signal numérique (L1 ; L2 ; L3) commandant simultanément un commutateur (M1, M'1, M4 ; M2, M'2, M5 ; M3, M'3, M6) de chaque résistance variable.

**10.** Filtre selon l'une quelconque des revendications 1 à 9, **caractérisé en ce qu'**il est appliqué à la correction de fréquences aiguës d'un signal audio analogique.

**Patentansprüche**

**1.** Analoges Aktivfilter mit einem Differenzverstärker (1), der an einem Ausgang ein gefiltertes Signal (Vs) abgibt und von welchem ein nicht-invertierender Eingang mit einem Median- bzw. Mittelpotential (Vm) zwischen den Speisespannungen des Verstärkers (1) verbunden ist,
**dadurch gekennzeichnet, daß** der Verstärker umfaßt:

eine erste Reihenschaltungskombination aus einem ersten Festwiderstand (R4) und einem ersten veränderbaren Widerstand (R5) zwischen einem Eingangsanschluß für ein zu filterndes Signal (Ve) und einem invertierenden Anschluß des Verstärkers (1);

eine zweite Reihenschaltungskombination aus einem zweiten Festwiderstand (R'4) und einem zweiten veränderbaren Widerstand (R'5) zwischen dem Ausgang des Verstärkers (1) und seinem invertierenden Eingang;

einen dritten veränderbaren Widerstand (R6) in Reihe mit einem Filterkondensator (C), zwischen einem Knoten- bzw. Zwischenpunkt (A, B) einer der genannten Reihenschaltungskombinationen (R4,R5; R'4,R'5) und dem genannten Medianpotential (Vm).

**2.** Filter nach Anspruch 1, **dadurch gekennzeichnet, daß** die Widerstände (R4,R5,R'4,R'5,R6) und der Verstärker (1) in Form einer integrierten Schaltung ausgebildet sind, wobei ein erster Anschluß des dritten veränderbaren Widerstands (R6) mit einem Anschlußkontakt (5) zum Anschluß des bezüglich der integrierten Schaltung externen Kondensators (C) verbunden ist, und wobei ein zweiter Anschluß des dritten veränderbaren Widerstands (R6) mit dem genannten Knoten- bzw. Zwischenpunkt (A, B) einer der genannten Reihenschaltungskombinationen verbunden ist.

**3.** Filter nach Anspruch 1 oder 2, **dadurch gekennzeichnet, daß** der dritte veränderbare Widerstand (R6) mit dem Knoten- bzw. Zwischenpunkt (A) der ersten Reihenschaltungskombination (R4,R5) verbunden ist und das Filter einen Verstärker bildet.

**4.** Filter nach Anspruch 1 oder 2, **dadurch gekennzeichnet, daß** der dritte veränderbare Widerstand (R6) mit dem Knoten- bzw. Zwischenpunkt (B) der zweiten Reihenschaltungskombination (R'4,R'5) verbunden ist und das Filter eine Dämpfungs- bzw.

Schwächungsvorrichtung bildet.

5. Filter nach einem der Ansprüche 1 bis 4, **dadurch gekennzeichnet, daß** es Umschaltmittel (MP7,MN7,MN8,MP8) zur Wahl des Knoten- bzw. Zwischenpunkts (A, B), mit welchem der dritte veränderbare Widerstand (R6) verbunden ist, aufweist.

6. Filter nach Anspruch 5, **dadurch gekennzeichnet, daß** die genannten Umschaltmittel durch zwei CMOS-Schalter (MP7,MN7; MN8, MP8) gebildet werden.

7. Filter nach einem der Ansprüche 1 bis 6, **dadurch gekennzeichnet, daß** jeder der veränderbaren Widerstände (R5; R'5; R6) jeweils aus in Reihe geschalteten und Umschaltern (M1,M2,M3; (M'1,M'2,M'3; M4,M5,M6) zugeordneten Festwiderständen (R51,R52, R53,R54; R'51,R'52,R'53,R'54; R61,R62,R63,R64) besteht.

8. Filter nach Anspruch 7, **dadurch gekennzeichnet, daß** die die veränderbaren Widerstände (R5; R'5; R6) bildenden Umschalter (M1,M2,M3; M'1,M'2,M'3; M4,M5,M6) N-Kanal-MOS- Transistoren sind.

9. Filter nach Anspruch 7 oder 8, **dadurch gekennzeichnet, daß** die die veränderbaren Widerstände (R5; R'5; R6) bildenden Umschalter (M1,M2,M3; M'1,M'2,M'3; M4,M5,M6) durch digitale Signale (L1,L2,L3) gesteuert werden, wobei jeder veränderbare Widerstand (R5; R'5; R6) jeweils eine gleiche Anzahl von Umschaltern aufweist und jedes digitale Signal (L1; L2; L3) jeweils gleichzeitig einen Umschalter (M1,M'1,M4; M2,M'2,M5; M3,M'3,M6) jedes veränderbaren Widerstands steuert.

10. Filter nach einem der Ansprüche 1 bis 9, **dadurch gekennzeichnet, daß** es zur Korrektur der hohen Frequenzen eines analogen Audiosignals angewandt wird.

**Claims**

1. An analog active filter including a differential amplifier (1), an output of which issues a filtered signal (Vs) and a non-inverting input of which is connected to a median potential (Vm) between supply potentials of the amplifier (1), **characterized in that** it includes:

   a first series association of a first fixed resistor (R4) and of a first variable resistor (R5) between an input terminal of a signal to be filtered (Ve) and an inverting input terminal of the amplifier (1) ;
a second series association of a second fixed resistor (R'4) and of a second variable resistor (R'5) between the output of the amplifier (1) and its inverting input; and
a third variable resistor (R6) in series with a filtering capacitor (C), between a midpoint (A, B) of one of the series associations (R4, R5; R'4, R'5) and the median potential (Vm).

2. A filter according to claim 1, **characterized in that** the resistors (R4, R5, R'4, R'5, R6) and the amplifier (1) are implemented in the form of an integrated circuit, a first terminal of the third variable resistor (R6) being connected to a terminal (5) for connecting the external capacitor (C) to the integrated circuit, and a second terminal of the third variable resistor (R6) being connected to the midpoint (A, B) of one of the series associations.

3. A filter according to claim 1 or 2, **characterized in that** the third variable resistor (R6) is connected to the midpoint (A) of the first series association (R4, R5), the filter constituting an amplifier.

4. A filter according to claim 1 or 2, **characterized in that** the third variable resistor (R6) is connected to the midpoint (B) of the second series association (R'4, R'5), the filter constituting an attenuator.

5. A filter according to any of claims 1 to 4, **characterized in that** it includes switching means (MP7, MN7, MN8, MP8) for selecting the midpoint (A, B) to which the third variable resistor (R6) is connected.

6. A filter according to claim 5, **characterized in that** the switching means are comprised of two CMOS switches (MP7, MN7; MN8, MP8).

7. A filter according to any of claims 1 to 6, **characterized in that** each of the variable resistors (R5; R'5; R6) is comprised of fixed resistors (R51, R52, R53, R54; R'51, R'52, R'53, R'54; R61, R62, R63, R64) mounted in series and associated with switches (M1, M2, M3; M'1, M'2, M'3; M4, M5, M6).

8. A filter according to claim 7, **characterized in that** the switches (M1, M2, M3; M'1, M'2, M'3; M4, M5, M6) constitutive of the variable resistors (R5; R'5; R6) are N-channel MOS transistors.

9. A filter according to claim 7 or 8, **characterized in that** the switches (M1, M2, M3; M'1, M'2, M'3; M4, M5, M6) constitutive of the variable resistors (R5; R'5; R6) are controlled by digital signals (L1, L2, L3), each variable resistor (R5, R'5, R6) including a same number of switches and each digital signal (L1; L2; L3) simultaneously controlling one switch (M1, M'1, M4; M2, M'2, M5; M3, M'3, M6) of each variable resistor.

10. A filter according to any of claims 1 to 9, **characterized in that** it is applied to correcting high frequencies of an analog audio signal.

Fig 1

Fig 2

Fig 3

Fig 4

Fig 5

Fig 6

10

Fig 7

EP 0 810 728 B1

11